# EUROPEAN PATENT SPECIFICATION

(11) **EP 1 705 262 B1**
(45) Date of publication and mention of the grant of the patent: **27.10.2010**
(21) Application number: 06251531.7
(22) Date of filing: 22.03.2006
(51) Int. Cl.: C23C 14/04, C23C 16/04

(54) **Gas manifold with a flow divider**
Gasverteiler mit einem Strömungsteiler
Distributeur de gaz avec un diviseur de débit

(30) Priority: 24.03.2005 US 89989
(43) Date of publication of application: 27.09.2006
(73) Proprietor: United Technologies Corporation, Hartford, CT 06101 (US)
(72) Inventor: Olson, Walter E., Vernon, CT 06066 (US); Gartland, Mathew C., Trumbull, CT 06611 (US)
(74) Representative: Leckey, David Herbert

(56) References cited:
- EP-A- 1 445 345
- US-A- 5 928 725

## Description

### BACKGROUND OF THE INVENTION

### (1) Field of the Invention

The present invention relates to an improved process for coating the internal surfaces of workpieces, such as turbine blades and vanes, having internal passageways and to a manifold used in the process.

### (2) Prior Art

Aluminide coatings provide protection against oxidation and corrosion degradation to nickel and cobalt based superalloy articles used in gas turbine engines. In general, aluminide coatings are formed by heating a powder mixture containing a source of aluminum, an activator, and an inert buffer or diluent, in the presence of the article to be coated. The article may be located in out-of-contact relation with the powder mixture, hence the process is called a vapor phase process.

When coating internal surfaces of turbine blades and vanes to protect the internal surfaces, a sufficient amount of aluminide coating gas must pass in contact with the surface in order to produce a NiAl diffusion coating of the required thickness and composition. The ability of the coating process to effectively and uniformly coat the internal surfaces is a direct function of the distribution and flow of the aluminum halide carrier gas through the internal passages. Factors making internal coating coverage more difficult are: (1) complex serpentine passages; (2) long distance and/or high aspect ratio (length-to-width/cross section) passages; (3) very narrow passages; and 4) an array of different size passage openings.

One such process involves flowing an aluminum halide gas, such as AlF₃, under pressure through an opening in the root of a workpiece allowing the gas to penetrate all internal passages. Depending upon the design of the workpiece, there usually are multiple openings in the base of the workpiece to allow flow into the various internal passages. The gas is introduced into the blade through a manifold that is sealed to the base of the blade to direct all flow to the internal cavities and prevent leakage to the outside. The ability of the aluminum halide gas to coat long narrow passages, or very winding, long serpentine passages is directly related to the ability of the manifold design to get sufficient gas flow for the full length of the passage.

US 5,928,725 describes a method and apparatus for gas phase coating of complex internal surfaces of hollow articles.

Currently, there is no provision in the manifold design to control the amount of flow that enters each of the openings in the base of the blade root.

### SUMMARY OF THE INVENTION

According to a first aspect of the present invention there is provided a manifold as claimed in claim 1.

According to a second aspect of the present invention there is provided a system as claimed in claim 4.

According to a third aspect of the present invention there is provided a process as claimed in claim 7.

The invention provides a manifold which allows the flow of a coating gas to be selectively higher to some locations.

The invention also provides an improved process for coating internal passageways of a workpiece.

Other details of the vapor aluminide coating gas manifold of the present invention, as well as other advantages attendant thereto, are set forth in the following detailed description and the accompanying drawing wherein like reference numerals depict like elements.

### BRIEF DESCRIPTION OF THE DRAWINGS

FIG. 1 is a schematic representation of a first embodiment of a system for coating internal passages of a workpiece using a manifold in accordance with the present invention; and
FIG. 2 is a schematic representation of a system for coating internal passages of a workpiece using a plurality of manifolds which is outside the scope of the claims.

### DETAILED DESCRIPTION OF THE PREFERRED EMBODIMENT(S)

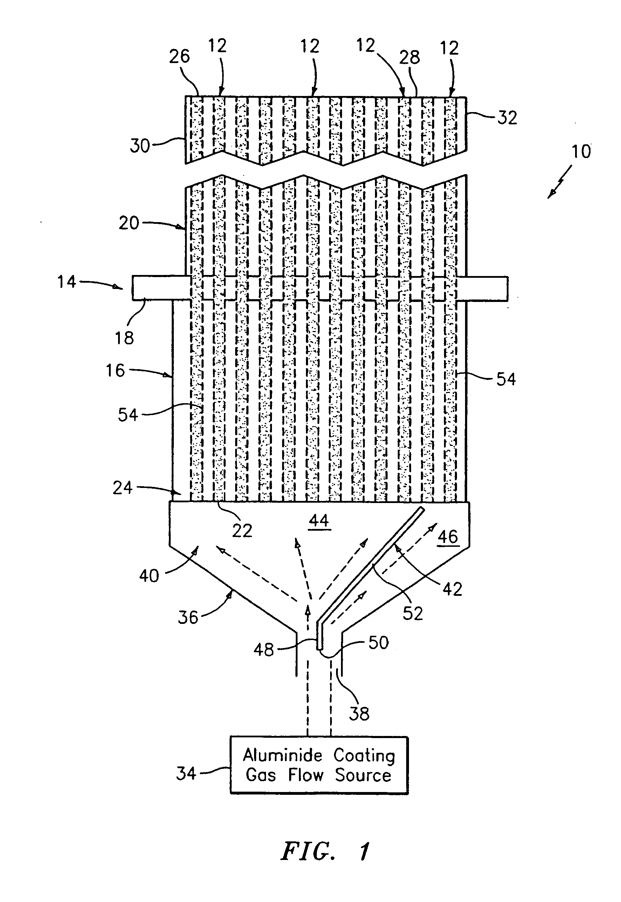

Referring now to FIG. 1, there is shown a system 10 for coating internal passages 12 of a workpiece 14, such as a blade or vane for use in a turbine engine. The workpiece 14 may have a root portion 16, a platform 18, and an airfoil portion 20. A plurality of internal passages 12 may extend from an opening 22 in the base 24 of the workpiece to an outlet cooling hole 26 at a tip end 28 of the airfoil portion 20. While the passages 12 have been shown as being linear passageways, it should be recognized that the passages 12 could be serpentine or otherwise non-linearly shaped. Often cross section dimensions, such as the diameters, of the passages 12 change across the width of the airfoil portion 20. For example, the passage 12 adjacent the leading edge 30 of the airfoil portion 20 may have a relatively large cross section dimension, while the passage 12 adjacent the trailing edge 32 of the airfoil portion 20 may have a relatively small cross section dimension. As a result, the cooling hole 26 adjacent the leading edge 30 may have a cross section dimension which is greater than the cross section dimension of the cooling hole 26 adjacent the trailing edge 32.

The system 10 includes a source 34 of an aluminide coating gas, such as AlF₃ gas. This gas may be generated in a remote location by a reaction of a halide activator (ie. AlF₃, NH₄F.HF, NH₃Cl, AlCl₃, etc.) with an aluminum-rich source metal (ie. CrAl, Co₂Al₅, NiAl, pure Al, etc.) at coating process temperature and fed to the inlet of the manifold by an Ar carrier gas. A typical aluminide coating process is from about 2 to 8 hours at a temperature in the range of 927-1149°C (1700 - 2100°F). Gas flows for internal coating range from 7.87 to 117.99 cm³/s (1.0 to 15.0 cfh) per part with higher pressures being used for longer or more complex passages.

The system 10 further includes a flow manifold 36 which has an inlet 38 for receiving the aluminide coating gas from the source 34. The inlet 38 may communicate with the source 34 using any suitable means known in the art. The manifold 36 may be attached to the base 24 of the workpiece 12 by any suitable means known in the art. Preferably, the manifold 36 is attached to the base 24 in a way which prevents gas leakage between the manifold 36 and the base 24.

As can be seen from FIG. 1, the manifold 36 has an internal chamber 40 with a flow diverter 42 separating the chamber 40 into a first section 44 and a second section 46. To insure that the smaller cross section dimension passageways are coated to a desired thickness and the desired uniformity, the flow diverter 42 is set to cause a controlled portion of the incoming coating gas to flow into the opening 22 of the smaller cross section dimension passages(s). The actual percentage of flow which may be diverted is a function of the passage size and configuration.

As can be seen from FIG. 1, the flow diverter 42 has a first portion 48 which has a leading edge 50 within the inlet 38 of the manifold 36. The flow diverter 42 also has a second portion 52 which is angled with respect to the first portion 48. The second portion 52 extends to a point very close to or adjacent the outlet of the manifold 36. The flow diverter 42 prevents any flow of the coating gas between the sections 44 and 46.

The flow diverter 42 may be stationary or movable so that the flow of the coating gas may be apportioned as needed. For example, the portion 48 of the flow diverter may be laterally movable within the inlet 38 to apportion the gas flow as needed. Alternatively, the second portion 52 may be movable relative to the first portion 48 to change the relative size of the sections 44 and 46 and hence the amount of coating gas flow to the rearmost passage or passages 12.

The provision of the flow diverter 42 allows a greater flow of coating gas to be directed to difficult to coat passages while still providing sufficient flow to the rest of the openings 22 to allow the formation of an acceptable coating on all internal surfaces 54.

The coating trial results shown in Tables I and II demonstrate the benefits of the manifold design of the present invention. In this trial, a turbine blade with internal passages had the internal passages coated. The turbine blade which was used had a first passage adjacent the leading edge and a cooling hole with a diameter of 3.35 mm (0.132 inches), had second through eleventh passages and cooling holes with a diameter of 3.00 mm (0.118 inches), and a twelfth passageway, adjacent the trailing edge, and a cooling hole with a diameter of 1.75 mm (0.069 inches). Each outlet cooling hole was about 25.4 cm (10 inches) above the manifold. The trial results shown in Table I are for a system where the manifold did not have a flow diverter in accordance with the present invention. The trial results shown in Table II are for a system wherein the manifold had a flow diverter in accordance with the present invention. As can be seen from this data, hole 12 did not coat at the outer extremity without the diverter.

**TABLE I**

| | PWA 275 Coating Thickness (mils) (1 mil = 0.0254 mm) Without Manifold Diverter | | | | | | |
|---|---|---|---|---|---|---|---|
| Distance above the manifold | Hole 1 | Hole 2 | Hole 5 | Hole 7 | Hole 9 | Hole 11 | Hole 12 |
| 10" (25.4 cm) | 1.7 | 1.8 | 1.9 | 1.8 | 1.8 | 1.8 | 0 |
| 8" (20.3 cm) | 1.8 | 1.9 | 1.9 | | | 1.8 | 1.1 |
| 5" (12.7 cm) | 1.7 | 1.8 | 1.8 | | | 1.8 | 1.3 |
| 0.5" (1.27 cm) | 1.6 | 1.8 | 1.7 | 1.7 | | 1.9 | 1.7 |

**TABLE II**

| | PWA 275 Coating Thickness (mils) (1 mil = .0254 mm) With Manifold Diverter | | | | | | |
|---|---|---|---|---|---|---|---|
| Distance above the manifold | Hole 1 | Hole 2 | Hole 5 | Hole 7 | Hole 9 | Hole 11 | Hole 12 |
| 10" (25.4 cm) | 1.5 | 1.7 | 1.7 | 1.6 | 1.6 | 1.6 | 1.0 |
| 8" (20.3 cm) | 1.5 | 1.7 | 1.8 | 1.7 | 1.7 | 1.7 | 1.4 |
| 5" (12.7 cm) | 1.6 | 1.7 | 1.8 | 1.7 | 1.7 | 1.8 | 1.5 |
| 0.5" (1.27 cm) | 1.6 | 1.6 | 1.5 | 1.6 | 1.5 | 1.5 | 1.7 |

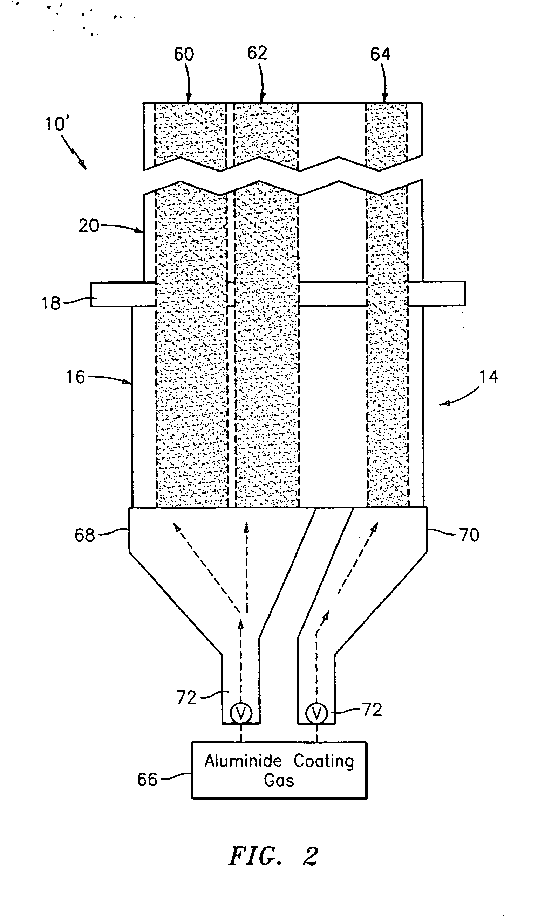

Referring now to FIG. 2, there is shown a system 10' for coating internal passages in a workpiece 14 which is outside the scope of the claims. As before, the workpiece 14, such as a blade or vane for use in a turbine engine, may have a root portion 16, a platform 18, and an airfoil portion 20. The workpiece 14 may have one or more leading edge passages 60, one or more midbody passages 62, and one or more trailing edge passages 64. As before, there is a source 66 of a coating gas such as an aluminide coating gas.

As can be seen from FIG. 2, the system 10' has a first flow manifold 68 and a second flow manifold 70. The first flow manifold 68 provides a first incoming coating gas flow to the inlets of the passages 60 and 62. The second flow manifold 70 provides a second incoming coating gas flow to the passage or passages 64. Suitable means, such as valves, may be provided for controlling the quantity of gas which flows through each of the manifolds 68 and 70. This approach allows each manifold 68 and 70 to flow at a different rate.

While a single coating gas source 66 has been shown in FIG. 2, more than one coating gas source may be used. For example, each of the manifolds 68 and 70 may have its inlet 72 communicating with a separate coating gas source.

In an embodiment which is in accordance with the present invention, one or more of the manifolds 68 and 70 may be provided with a flow diverter 42 as described hereinabove.

## Claims

1. A manifold (36) for use in a process for coating different sized passages in a workpiece comprising:
an internal chamber (40);
an inlet (38) for receiving a flow of a coating gas; and
a flow diverter (42) within the internal chamber (40) for separating the flow of coating gas into a first flow sufficient to coat a full length of surfaces of a first internal passage set having a first cross section dimension and a second flow sufficient to coat a full length of surfaces of a second internal passage set having a second cross section dimension smaller than said first cross section dimension, wherein said flow diverter (42) has a first portion (48) which extends into said inlet (38) and a second portion (52) angled relative to said first portion (48) and wherein said manifold has an outlet and said second portion (52) extends from said first portion (48) to a point in close proximity to said outlet.

2. A manifold according to claim 1, wherein said flow diverter (42) is stationary within said chamber.

3. A manifold according to claim 1, wherein said flow diverter (42) is movable within said chamber.

4. A system (10) for coating internal passages (12) of a workpiece (14) comprising:
a source (34) of a coating gas; and
a manifold (36) as claimed in any preceding claim connected to said source (34) of said coating gas and to said workpiece.

5. A system according to claim 4, wherein said source (34) of said coating gas comprises a source of aluminum halide gas.

6. A system according to claim 4, wherein said source (34) of said coating gas comprises a source of AlF₃.

7. A process for coating internal passages (12) of a turbine engine component (14), said process comprising the steps of:
providing a source (34) of a coating gas;
providing a manifold (36) according to any one of claims 1 to 3 that is connected to said source of said coating gas and to said workpiece; and
separating the flow of coating gas within said manifold (36) into a first flow sufficient to coat a full length of surfaces of a first internal passage set having a first cross section dimension and a second flow sufficient to coat a full length of surfaces of a second internal passage set having a second cross section dimension smaller than said first cross section dimension.

8. A process according to claim 7, further comprising delivering said first flow to an opening of each of a plurality of passages forming said first internal passage set and delivering said second flow to an opening of at least one internal passage forming said second internal passage set.

9. A process according to claim 8, wherein said second flow delivering step comprises delivering said second flow to a plurality of internal passages forming said second internal passage set.

10. A process according to claim 7, 8 or 9, wherein said step of providing a source (34) of a coating gas comprises providing a source of aluminum halide gas.

11. A process according to claim 7, 8 or 9, wherein said step of providing a source of a coating gas comprises providing a source of AlF₃.

## Patentansprüche

1. Verteiler (36) zur Verwendung in einem Prozess für die Beschichtung von unterschiedlich dimensionierten Passagen in einem Werkstück, aufweisend:
eine interne Kammer (40);
einen Einlass (38) zum Empfangen einer Strömung eines Beschichtungsgases; und
einen Strömungsteiler (42) innerhalb der internen Kammer (40) zum Trennen der Strömung des Beschichtungsgases in eine erste Strömung, die zum Beschichten einer vollen Länge von Oberflächen eines ersten Satzes von internen Passagen mit einer ersten Querschnittsabmessung ausreichend ist, und eine zweite Strömung, die zum Beschichten einer vollen Länge von Oberflächen eines zweiten Satzes von internen Passagen mit einer zweiten Querschnittsabmessung, die kleiner ist als die erste Querschnittsabmessung, ausreichend ist, wobei der Strömungsteiler (42) einen ersten Bereich (48) aufweist, der sich in den Einlass (38) hinein erstreckt, und einen zweiten Bereich (52) aufweist, der relativ zu dem ersten Bereich (48) in einem Winkel angeordnet ist, und wobei der Verteiler einen Auslass aufweist und sich der zweite Bereich (52) von dem ersten Bereich (48) zu einer Stelle in unmittelbarer Nähe von dem Auslass erstreckt.

2. Verteiler nach Anspruch 1,
wobei der Strömungsteiler (42) im Inneren der Kammer stationär ist.

3. Verteiler nach Anspruch 1,
wobei der Strömungsteiler (42) im Inneren der Kammer beweglich ist.

4. System (10) zum Beschichten von internen Passagen (12) eines Werkstücks (14), aufweisend:
eine Quelle (34) eines Beschichtungsgases; und
einen Verteiler (36) nach einem der vorausgehenden Ansprüche, der mit der Quelle (34) des Beschichtungsgases und mit dem Werkstück in Verbindung steht.

5. System nach Anspruch 4,
wobei die Quelle (34) des Beschichtungsgases eine Aluminiumhalogenidgas-Quelle aufweist.

6. System nach Anspruch 4,
wobei die Quelle (34) des Beschichtungsgases eine AlF₃-Quelle aufweist.

7. Verfahren zum Beschichten von internen Passagen (12) einer Turbinenmaschinenkomponente (14), wobei das Verfahren folgende Schritte aufweist:
Bereitstellen einer Quelle (34) eines Beschichtungsgases;
Bereitstellen eines Verteilers (36) nach einem der Ansprüche 1 bis 3, der mit der Quelle des Beschichtungsgases und mit dem Werkstück in Verbindung steht; und
Trennen der Strömung des Beschichtungsgases innerhalb des Verteilers (36) in eine erste Strömung, die zum Beschichten einer vollen Länge von Oberflächen eines ersten Satzes von internen Passagen mit einer ersten Querschnittsabmessung ausreichend ist, und eine zweite Strömung, die zum Beschichten einer vollen Länge von Oberflächen eines zweiten Satzes von internen Passagen mit einer zweiten Querschnittsabmessung, die kleiner ist als die erste Querschnittsabmessung, ausreichend ist.

8. Verfahren nach Anspruch 7,
das ferner das Zuführen der ersten Strömung zu einer Öffnung von jeder einer Mehrzahl von Passagen, die den ersten Satz von internen Passagen bilden, sowie das Zuführen der zweiten Strömung zu einer Öffnung von mindestens einer internen Passage, die den zweiten Satz von internen Passagen bilden, beinhaltet.

9. Verfahren nach Anspruch 8,
wobei der zweite Strömungs-Zuführschritt das Zuführen der zweiten Strömung zu einer Mehrzahl von internen Passagen beinhaltet, die den zweiten Satz von internen Passagen bilden.

10. Verfahren nach Anspruch 7, 8 oder 9,
wobei der Schritt der Bereitstellung einer Quelle (34) eines Beschichtungsgases das Bereitstellen einer Aluminiumhalogenidgas-Quelle beinhaltet.

11. Verfahren nach Anspruch 7, 8 oder 9,
wobei der Schritt des Bereitstellens einer Quelle eines Beschichtungsgases das Bereitstellen einer AlF₃-Quelle beinhaltet.

## Revendications

1. Distributeur (36) à utiliser dans un procédé pour revêtir plusieurs passages calibrés dans une pièce, comprenant:
une chambre interne (40);
une entrée (38) pour recevoir un écoulement d'un gaz de revêtement; et
un diviseur de débit (42) à l'intérieur de la chambre interne (40) pour séparer l'écoulement de gaz de revêtement en un premier écoulement suffisant pour revêtir la totalité de la longueur de surfaces d'un premier ensemble de passages internes présentant une première dimension de section transversale, et un deuxième écoulement suffisant pour revêtir la totalité de la longueur de surfaces d'un deuxième ensemble de passages internes présentant une deuxième dimension de section transversale qui est plus petite que ladite première dimension de section transversale, dans lequel ledit diviseur de débit (42) comprend une première partie (48) qui s'étend dans ladite entrée (38), et une deuxième partie (52) inclinée par rapport à ladite première partie (48), et dans lequel ledit distributeur comprend une sortie, et ladite deuxième partie (52) s'étend à partir de ladite première partie (48) jusqu'à un point qui est situé dans le voisinage immédiat de ladite sortie.

2. Distributeur selon la revendication 1, dans lequel ledit diviseur de débit (42) est stationnaire à l'intérieur de ladite chambre.

3. Distributeur selon la revendication 1, dans lequel ledit diviseur de débit (42) est mobile à l'intérieur de ladite chambre.

4. Système (10) pour revêtir des passages internes (12) d'une pièce (14), comprenant:
une source (34) d'un gaz de revêtement; et
un distributeur (36) selon l'une quelconque des revendications précédentes, qui est connecté à ladite source (34) dudit gaz de revêtement et à ladite pièce.

5. Système selon la revendication 4, dans lequel ladite source (34) dudit gaz de revêtement comprend une source de gaz d'halogénure d'aluminium.

6. Système selon la revendication 4, dans lequel ladite source (34) dudit gaz de revêtement comprend une source d'AlF₃.

7. Procédé pour revêtir des passages internes (12) d'un composant de moteur à turbine (14), ledit procédé comprenant les étapes:
fournir une source (34) d'un gaz de revêtement;
prévoir un distributeur (36) selon l'une quelconque des revendications 1 à 3, qui est connecté à ladite source dudit gaz de revêtement et à ladite pièce; et
séparer l'écoulement de gaz de revêtement à l'intérieur dudit distributeur (36) en un premier écoulement suffisant pour revêtir la totalité de la longueur de surfaces d'un premier ensemble de passages internes présentant une première dimension de section transversale, et un deuxième écoulement suffisant pour revêtir la totalité de la longueur de surfaces d'un deuxième ensemble de passages internes présentant une
deuxième dimension de section transversale qui est plus petite que ladite première dimension de section transversale.

8. Procédé selon la revendication 7, comprenant en outre la distribution dudit premier écoulement à une ouverture de chacun d'une pluralité de passages qui forment ledit premier ensemble de passages internes, et la distribution dudit deuxième écoulement à une ouverture d'au moins un passage interne qui forme ledit deuxième ensemble de passages internes.

9. Procédé selon la revendication 8, dans lequel ladite étape de distribution du deuxième écoulement comprend la distribution dudit deuxième écoulement à une pluralité de passages internes qui forment ledit deuxième ensemble de passages internes.

10. Procédé selon la revendication 7, 8 ou 9 dans lequel ladite étape de fourniture d'une source (34) de gaz de revêtement comprend la fourniture d'une source de gaz d'halogénure d'aluminium.

11. Procédé selon la revendication 7, 8 ou 9, dans lequel ladite étape de fourniture d'une source de gaz de revêtement comprend la fourniture d'une source de AlF₃.
